# EUROPEAN PATENT APPLICATION

(11) **EP 4 152 590 A1**
(43) Date of publication of application: **22.03.2023**
(21) Application number: 21802186.3
(22) Date of filing: 13.04.2021
(51) Int. Cl.: H02N 11/00

(54) **ACTUATOR AND POWER USAGE DEVICE**

(30) Priority: 14.05.2020 JP 2020084878
(71) Applicant: Kabushiki Kaisha Us Research, Miyagi 982-0831 (JP)
(72) Inventor: ONO, Takahito, Sendai-shi, Miyagi 980-8577 (JP)
(74) Representative: Plougmann Vingtoft a/s
(86) International application number: PCT/JP2021/015364
(87) International publication number: WO 2021/229982

(57) **Abstract**

An actuator and a power usage device which can be reduced in size and can suppress power consumption are provided.

Flow-in means 12 is provided capable of causing a spin current to flow into a magnetostrictive material 11. The flow-in means 12 has a conductive body 12a provided along a surface of the magnetostrictive material 11 and capable of generating the spin current when an electric current flows and electric-current supply means which causes the electric current to flow in the conductive body 12a. Magnetic-field applying means is provided to apply, to the magnetostrictive material 11, a magnetic field orthogonal or diagonal to a direction of the electric current caused to flow in the conductive body 12a by the electric-current supply means and a flow direction of the spin current generated in the conductive body 12a.

## Description

### Field of the Invention

The present invention relates to an actuator and a power usage device.

### Description of Related Art

Conventionally, those using a piezoelectric material have been widely used as small-sized actuators, but since a maximum distortion of the piezoelectric material is small, the development of an actuator using a magnetostrictive material capable of generating larger distortion has been promoted (see Patent Literature 1, for example).

As a method of measuring the distortion of the magnetostrictive actuator, there is a method of measuring a change in a magnetic field generated when the magnetostrictive material is distorted by using a magnetic sensor such as a Hall element, and the Hall element is disposed in the vicinity of the magnetostrictive material so as to measure the magnetic field generated by the magnetostrictive material, for example (see Non Patent Literature 1, for example). However, with this method, the Hall element needs to be incorporated separately, which has difficulty in size reduction and costs.

Moreover, there is known such a method that a Pt thin film is formed on a Y₃Fe₅O₁₂ (YIG) substrate so that, when the YIG is vibrated, a spin wave is generated by spin-pumping and flows into the Pt thin film, and the spin wave is converted to a voltage by an inverse spin-hall effect (see Non Patent Literature 2, for example). However, since the YIG has an extremely small magnetostrictive constant at approximately 2 ppm, it cannot be used as a magnetostrictive actuator.

### Citation List

Patent Literature 1: JP-A-2004-335502

### Non Patent Litearture

Non Patent Literature 1: Zhen-Yuan Jia, Hui-Fang Liu, Fu-Ji Wang, Wei Liu, Chun-Ya Ge, "A novel magnetostrictive static force sensor based on the giant magnetostrictive material", Measurement, 2011, 44, 1, p.88-95
Non Patent Literature 2: K. Uchida, H. Adachi, T. An, H. Nakayama, M. Toda, B. Hillebrands, S. Maekawa, and E. Saitoh, "Acoustic spin pumping: Direct generation of spin currents from sound waves in Pt/Y3Fe5O12 hybrid structures", Journal of Applied Physics, 2012, 111, 053909

### Summary of the Invention

An actuator using the magnetostrictive material as described in Patent Literature 1 needs to generate a large magnetic field by using an electromagnet or the like in order to drive the magnetostrictive material and thus, size-reduction is difficult, and power consumption is large, which are problems.

The present invention was made in view of the problems as described above and has an object to provide an actuator and a power usage device which can be reduced in size and can suppress power consumption.

In order to achieve the aforementioned object, the inventor examined a relationship between the magnetostrictive material and a spin current and found out that the following two phenomena are generated by injecting the spin current into the magnetostrictive material. The first phenomenon is a phenomenon that magnetic spin polarization of the magnetostrictive material is changed by the spin current, and distortion is generated in the magnetostrictive material, and the second phenomenon is a phenomenon that fluctuation of magnetic spin of the magnetostrictive material is changed by the spin current, and a volume of the magnetostrictive material is expanded. The inventor thought that the magnetostrictive material can be driven by using these two phenomena and reached the present invention.

In other words, the actuator according to the present invention is characterized by having a magnetostrictive material and flow-in means provided capable of causing a spin current to flow into the magnetostrictive material.

The actuator according to the present invention can generate distortion in the magnetostrictive material, can expand the volume of the magnetostrictive material, and can drive the magnetostrictive material by causing the spin current to flow into the magnetostrictive material by the flow-in means. The spin current can be generated simply by causing an electric current to flow by using the spin-hall effect, for example. Therefore, size-reduction can be promoted, and power consumption can be suppressed.

Since the actuator, according to the present invention, can be reduced in size, it can be used as a micromirror, an acoustic/supersonic element, a small-sized pump, a small-sized motor, a small-sized drive mechanism, and a vibration sensor, for example.

In the actuator, according to the present invention, in order to generate the spin current by using the spin-hall effect, the flow-in means may have a conductive body provided along a surface of the magnetostrictive material and electric-current supply means which causes an electric current to flow in the conductive body, and the conductive body may be capable of generating the spin current when the electric current flows. In this case, distortion generated in the magnetostrictive material can be controlled by controlling the spin current by the electric current flowing in the conductive body.

Moreover, when this conductive body is provided, it is preferable to have magnetic-field applying means which applies, to the magnetostrictive material, a magnetic field orthogonal or diagonal to a direction of the electric current flowing in the conductive body by the electric-current supply means and a flow direction of the spin current generated in the conductive body. In this case, the spin current generated in the conductive body can be efficiently caused to flow into the magnetostrictive material by the magnetic-field applying means. Moreover, magneto-striction can be generated in the magnetostrictive material by the magnetic field of the magnetic-field applying means. The magnetic-field applying means may be a small permanent magnet, for example.

Moreover, the conductive body is preferably formed of a Pt, W, Ta, Bi-Te-based alloy, a Bi-Se-based alloy, or a Sb-Te-based alloy. Since they have large spin-hall coefficients, they can generate the spin current efficiently. Moreover, by using Pt with a positive spin-hall coefficient and W or Ta with negative spin-hall coefficients separately, a drive direction of the magnetostrictive material can be changed. Moreover, also by using Cu whose spin-hall coefficient is close to zero, the magnetostrictive material can be inhibited to be driven. Furthermore, by combining the conductive bodies formed of these different materials, the beam-shaped magnetostrictive material can be configured as capable of curving and/or twisting deformation by the flow-in spin current. By using the Bi-Te-based alloy, the Bi-Se-based alloy, or the Sb-Te-based alloy as the conductive body, the magnetostrictive material can be driven particularly largely.

The power usage device according to the present invention is characterized by having a magnetostrictive material capable of generating a spin current when deformed and power usage means provided so that the spin current flows in and using a potential difference generated by the flow-in spin current.

The power usage device according to the present invention can use the potential difference generated in the power usage means by the spin current, when the magnetostrictive material is deformed by distortion or a volume change, and the spin current is generated. The potential difference can be generated by using the electric current flowing by the spin current, using an inverse spin-hall effect or a magnetic impedance effect, for example. In the power usage device according to the present invention, the power usage means is a sensor which detects deformation of the magnetostrictive material from the potential difference, power generating means which generates power from the potential difference and the like, for example.

In the power usage device according to the present invention, in order to generate the potential difference by using the inverse spin-hall effect or the magnetic impedance effect, the power usage means preferably has a conductive body provided along a surface of the magnetostrictive material so that the spin current flows in and an electric current flows and is preferably configured to use the potential difference generated in the conductive body.

When this conductive body is provided, it is preferable to have magnetic-field applying means which applies, to the magnetostrictive material, a magnetic field orthogonal or diagonal to a direction of the electric current flowing in the conductive body and a flow direction of the spin current flowing into the conductive body. In this case, the spin current can be caused to flow into the conductive body efficiently by the magnetic field of the magnetic-field applying means, and the electric current can be caused to flow in the conductive body.

Moreover, the conductive body is preferably formed of a Pt, W, Ta, Bi-Te-based alloy, a Bi-Se-based alloy, or a Sb-Te-based alloy. Since they have large spin-hall coefficients, they can generate a potential difference by the spin-hall effect efficiently. Moreover, Pt with a positive spin-hall coefficient and W or Ta with negative spin-hall coefficients can be used separately depending on a displacement direction of the magnetostrictive material. Therefore, by combining the conductive bodies formed of these different materials, a configuration capable of generating the spin current can be realized depending on curving and/or twisting deformation of a beam-shaped magnetostrictive material, for example.

The actuator, according to the present invention, may be configured such that a fixed layer made of a ferromagnetic body and having a magnetizing direction fixed, a free layer made of the magnetostrictive material and having a changeable magnetizing direction, and a non-magnetic layer disposed between the fixed layer and the free layer are provided, the flow-in means has voltage applying means provided between the fixed layer and the free layer, capable of applying a voltage, and by applying the voltage by the voltage applying means, a spin-polarized electric current is injected from the fixed layer to the free layer so that the spin current can flow into the magnetostrictive material. In this case, by using a spin-valve structure made of the fixed layer, the free layer, and the non-magnetic layer, the spin current can be caused to flow into the magnetostrictive material of the free layer.

Moreover, when this spin-valve structure is to be used, the fixed layer, the free layer, and the non-magnetic layer may integrally form a beam shape and may be provided capable of curving and/or twisting deformation by the spin-polarized electric current injected into the free layer.

According to the present invention, the actuator and the power usage device, which can be reduced in size and can suppress power consumption, can be provided.

### Brief Description of the Drawings

Fig. 1(a) is a perspective view of an actuator of a first embodiment of the present invention, and Fig. 1(b) is a perspective view of power usage means of the embodiment of the present invention.
Fig. 2 is a perspective view of a magnetostrictive material with a double-supported beam structure, illustrating the actuator of the first embodiment of the present invention.
Fig. 3 is a perspective view of the magnetostrictive material with a cantilever structure illustrating the actuator of the first embodiment of the present invention.
Figs. 4 illustrate the actuator of the first embodiment of the present invention, in which Fig. 4(a) is a perspective view and Fig. 4(b) is a sectional view of a configuration capable of generating an elastic wave.
Fig. 5 is a side view of a configuration in which the magnetostrictive material and a conductive body are laminated alternately, illustrating the actuator of the first embodiment of the present invention.
Fig. 6 is a perspective view of a configuration capable of generating and detecting the elastic wave, illustrating the actuator of the first embodiment of the present invention and the power usage means of an embodiment of the present invention.
Fig. 7(a) is a graph illustrating a relationship between an applied magnetic field (Magnetic field) and displacement of the magnetostrictive material of the actuator shown in Fig. 2, and Fig. 7(b) is a graph illustrating a relationship between the applied magnetic field (Magnetic field) and a magnetostriction coefficient (Magnetostriction coefficient) only by magnetostriction of a comparative example.
Fig. 8(a) is a sample for reference not having the magnetostrictive material (Sample 1), Fig. 8(b) is a sample having an Au layer as the conductive body and a Galfenol layer as the magnetostrictive material (Sample 2), and Fig. 8(c) is a side view of a sample having the Au layer and a Bi₂Te₃ layer as the conductive body and the Galfenol layer as the magnetostrictive material (Sample 3) illustrating the double-supported beam structure used in an experiment for measuring the displacement of the magnetostrictive material of the actuator shown in Fig. 2.
Fig. 9 is a graph illustrating a relationship between the applied magnetic field (Magnetic field) and the displacement of the magnetostrictive material of the actuator using each of the samples with the double-supported beam structure shown in Figs. 8.
Fig. 10 is a side view illustrating a diaphragm structure used in an experiment for measuring a potential difference generated in the conductive body of the power usage means of the embodiment of the present invention when the magnetostrictive material is vibrated.
Fig. 11 is a side view illustrating an experiment device for measuring the potential difference generated in the conductive body when the magnetostrictive material is vibrated, using the diaphragm structure shown in Fig. 10.
Fig. 12(a) is a graph illustrating a relationship between a vibration frequency of PZT and an amplitude of an AC voltage generated on both ends of the conductive body, and Fig. 12(b) is a graph illustrating a relationship between the applied magnetic field and the amplitude of the AC voltage generated on the both ends of the conductive body at a resonant frequency of the diaphragm, obtained by the experiment device shown in Fig. 11.
Fig. 13 is a side view illustrating an actuator of a second embodiment of the present invention.
Fig. 14 is a perspective view of a configuration in which the fixed layer, the free layer, and the non-magnetic layer form the cantilever structure, illustrating the actuator of the second embodiment of the present invention.

### Detailed Description of the Invention

Hereinafter, embodiments of the present invention will be described on the basis of the drawings.

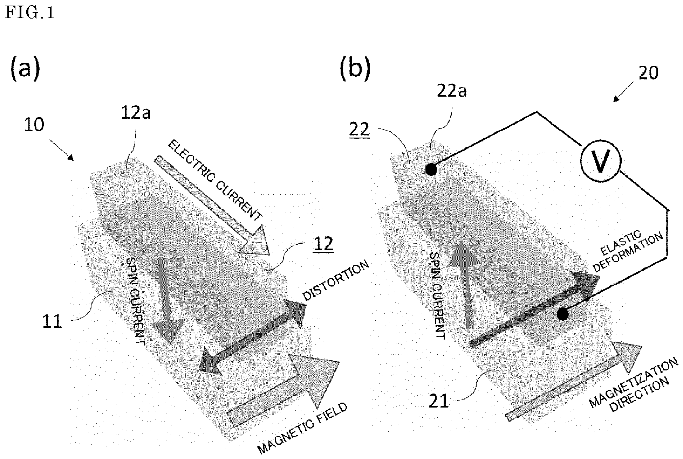

Figs. 1 to Figs. 12 illustrate an actuator and a power usage device of a first embodiment of the present invention.

As shown in Fig. 1(a), the actuator 10 of the first embodiment of the present invention has a magnetostrictive material 11, flow-in means 12, and magnetic-field applying means (not shown).

The magnetostrictive material 11 may be an alloy containing at least one or more of Fe, Co, and Ni, for example, but those with a magnetostriction coefficient at 100 ppm or more are preferable. More specifically, it may be a giant-magnetostrictive material such as Galfenol (Ga_{0.19}Fe_{0.81}), Terfenol-D (Tb_{0.3}Dy_{0.7}Fe₂) and the like in the market. The magnetostrictive material 11 is preferably formed with a thickness smaller in a direction to be deformed by distortion to be generated so that deformation is easy.

The flow-in means 12 has a conductive body12a provided along a surface of the magnetostrictive material 11 and power supply means (not shown) which causes an electric current to flow in the conductive body 12a. The conductive body 12a may have any configuration as long as a spin current can be generated when the electric current flows but is preferably formed of those with large spin-hall coefficients such as Pt, W, Ta, a Bi-Te-based alloy, a Bi-Se-based alloy, a Sb-Te-based alloy and the like. The flow-in means 12 is provided capable of causing the spin current generated in the conductive body 12a to flow in the magnetostrictive material 11, when the electric current is caused to flow in the conductive body 12a by the current supply means.

The magnetic-field applying means is provided capable of applying a magnetic field to the magnetostrictive material 11. The magnetic-field applying means is provided so as to apply, to the magnetostrictive material 11, a magnetic field orthogonal or diagonal to a direction of the electric current caused to flow in the conductive body 12a by the electric-current supply means and a flow direction of the spin current generated in the conductive body 12a. The magnetic-field applying means may be formed of one or a plurality of small-sized permanent magnets, for example. In a specific example shown in Fig. 1(a), the magnetic-field applying means can apply the magnetic field orthogonal to the direction of the electric current caused to flow in the conductive body 12a and the flow direction of the spin current.

Subsequently, an action will be described.

The actuator 10 can generate the spin current only by causing the electric current to flow in the conductive body 12a by using the spin-hall effect. Moreover, the actuator 10 can efficiently cause the spin current generated in the conductive body 12a to flow into the magnetostrictive material 11 by the magnetic-field applying means. As a result, the actuator 10 can generate distortion in the magnetostrictive material 11, expand a volume of the magnetostrictive material 11, or drive the magnetostrictive material 11.

Moreover, the actuator 10 can generate magnetostriction in the magnetostrictive material 11 by the magnetic field of the magnetic-field applying means. In the actuator 10, a drive direction of the magnetostrictive material 11 by the magnetostriction thereof does not orthogonally cross the drive direction of the magnetostrictive material 11 by the spin current and thus, the magnetostrictive material 11 can be driven more largely than a case only of the spin current or a case only of the magnetostriction.

Furthermore, since the actuator 10 can generate the spin current only by causing the electric current to flow, the size reduction can be promoted, and power consumption can be suppressed. Therefore, the actuator 10 can be used as a micromirror, an acoustic/supersonic element, a small-sized pump, a small-sized motor, a small-sized drive mechanism, and a sensor such as a vibration sensor, for example.

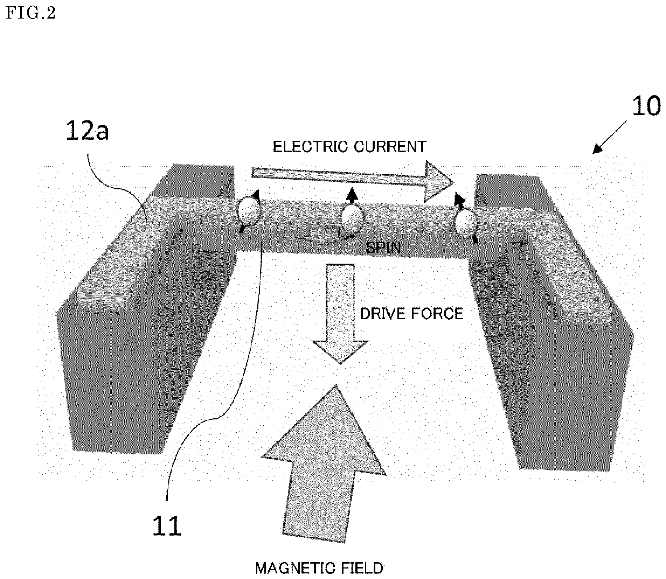

As shown in Fig. 2, in the actuator 10, the magnetostrictive material 11 may form the double-supported beam structure, for example, and the conductive body 12a may be provided on the surface of the magnetostrictive material 11 along a length direction of the magnetostrictive material 11. At this time, the electric current is caused to flow in the conductive body 12a by the electric-current supply means, and the magnetic field in a perpendicular direction to an aligning direction of the conductive body 12a and the magnetostrictive material 11 (flow direction of the spin current) and the length direction of the conductive body 12a is applied by the magnetic-field applying means. As a result, the magnetostrictive material 11 can be driven in the perpendicular direction to a beam length direction. The drive direction of the magnetostrictive material 11 can be made opposite by reversing the direction of the electric current caused to flow in the conductive body 12a or the direction of the magnetic field.

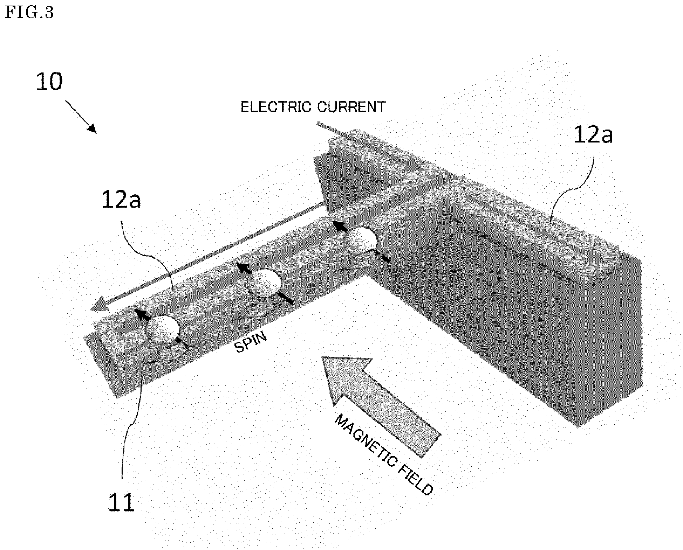

Moreover, as shown in Fig. 3, in the actuator 10, the magnetostrictive material 11 may form a cantilever structure, and the conductive body 12a may be provided on the surface of the magnetostrictive material 11 so as to reciprocate along the length direction of the magnetostrictive material 11. At this time, the electric current is caused to flow in the conductive body 12a by the electric-current supply means, and the magnetic field in the perpendicular direction to the aligning direction of the conductive body 12a and the magnetostrictive material 11 (flow direction of the spin current) and the length direction of the conductive body 12a is applied by the magnetic-field applying means. As a result, the magnetostrictive material 11 can be curved or twisted in accordance with the flow of the spin current injected into the magnetostrictive material 11 on an outgoing path of the conductive body 12a and the flow of the spin current injected into the magnetostrictive material 11 on a return path.

Specifically, when the direction of the electric current flowing in the conductive body 12a or the direction of the magnetic field are directions shown in Fig. 3, by using the conductive body 12a with the positive spin-hall coefficient (such as Pt) on the outgoing path and the conductive body 12a also with the positive spin-hall coefficient on the return path, when seen from a distal end side of the beam, the beam can be twisted counterclockwise. Moreover, by using the conductive body 12a with the negative spin-hall coefficient (such as W or Ta) on the outgoing path and the conductive body 12a also with the negative spin-hall coefficient on the return path, when seen from the distal end side of the beam, the beam can be twisted clockwise. Moreover, by using the conductive body 12a with the positive spin-hall coefficient on the outgoing path and the conductive body 12a with the negative spin-hall coefficient on the return path, the beam can be curved downward. Moreover, by using the conductive body 12a with the negative spin-hall coefficient on the outgoing path and the conductive body 12a with the positive spin-hall coefficient on the return path, the beam can be curved upward.

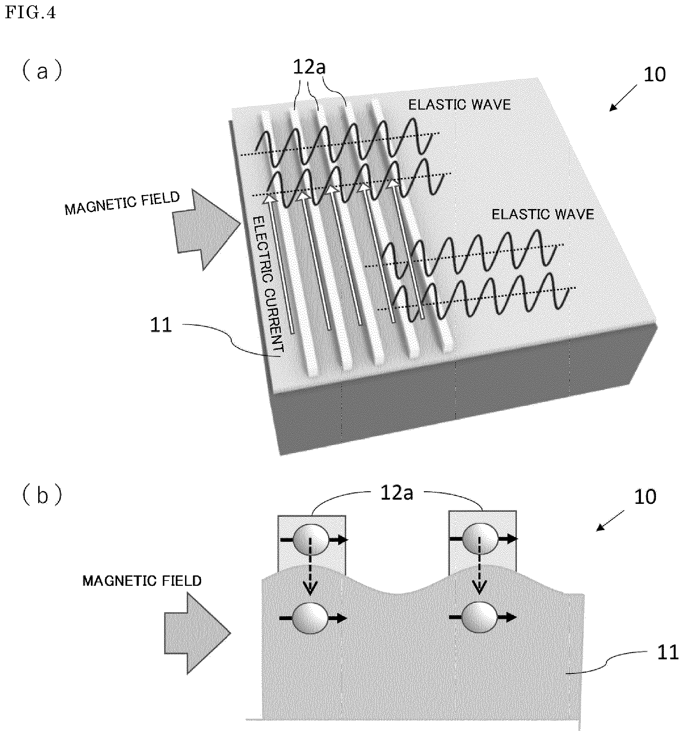

Moreover, as shown in Figs. 4, in the actuator 10, the magnetostrictive material 11 may be formed of a thin film, and a plurality of the conductive bodies 12a may be provided in parallel with each other at predetermined intervals on the surface of the magnetostrictive material 11. At this time, the electric current is caused to flow by the electric-current supply means in each of the conductive bodies 12a, and the magnetic field in the perpendicular direction to the aligning direction of the conductive body 12a and the magnetostrictive material 11 (flow direction of the spin current) and the length direction of each of the conductive bodies 12a is applied by the magnetic-field applying means. As a result, at the position of each of the conductive bodies 12a, the magnetostrictive material 11 is caused to expand in the thickness direction, whereby an elastic wave having the same wavelength as the interval between each of the conductive bodies 12a can be generated. Moreover, the elastic wave can be propagated along the aligning direction of the conductor bodies 12a in the magnetostrictive material 11. Furthermore, by changing the magnetic field to be applied, Young's modulus of the magnetostrictive material 11 can be changed, and a frequency of the elastic wave can be changed.

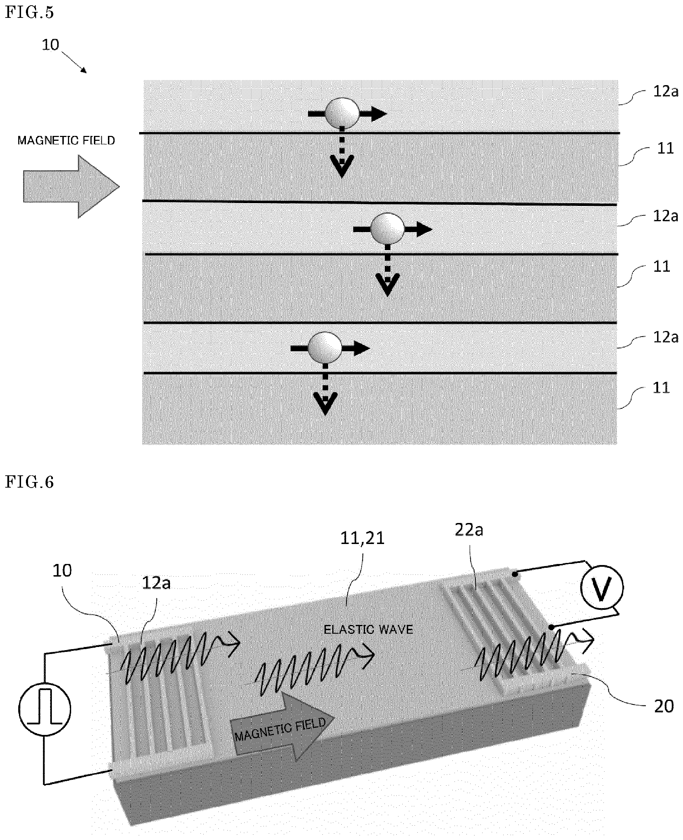

Moreover, as shown in Fig. 5, the actuator 10 may also be configured by alternately laminating the magnetostrictive material 11 made of a thin film and the conductive body 12a. In this case, since the distortion of each of the magnetostrictive materials 11 is superimposed in the same direction, drive capacity can be enhanced.

As shown in Fig. 1(b), the power usage device 20 has a magnetostrictive material 21, power usage means 22, and magnetic-field applying means (not shown).

The magnetostrictive material 21 is made of the one whose response to the magnetic field is changed when deformed and capable of generating a spin current. As the magnetostrictive material 21, the same one as that of the magnetostrictive material 11 of the actuator 10 shown in Fig. 1(a) can be used and it may be an alloy containing at least one or more of Fe, Co, and Ni, for example, but those with the magnetostriction coefficient of 100 ppm or more are preferable. More specifically, it may be a giant-magnetostrictive material such as Galfenol (Ga_{0.19}Fe_{0.81}), Terfenol-D (Tb_{0.3}Dy_{0.7}Fe₂) and the like in the market. The magnetostrictive material 21 is preferably formed with a thickness smaller in a direction to be deformed so that deformation is easy.

The power usage means 22 has a conductive body 22a provided along the surface of the magnetostrictive material 21. The conductive body 22a is provided so that the spin current generated in the magnetostrictive material 21 flows in and the electric current flows by spin pumping. As the conductive body 22a, the same one as that of the conductive body 12a of the actuator 10 shown in Fig. 1(a) can be used, and it may be formed of those with larger spin-hall coefficients such as Pt, W, Ta, the Bi-Te-based alloy, the Bi-Se-based alloy, the Sb-Te-based ally and the like, for example.

The magnetic-field applying means is provided capable of applying the magnetic field to the magnetostrictive material 21. The magnetic-field applying means is provided so as to apply, to the magnetostrictive material 21, the magnetic field orthogonal or diagonal to the direction of the electric current flowing in the conductive body 22a and the flow direction of the spin current flowing into the conductive body 22a. In the specific example shown in Fig. 1(b), the magnetic-field applying means is capable of applying the magnetic field orthogonal to the direction of the electric current flowing in the conductive body 22a and the flow direction of the spin current.

The power usage means 22 is configured so as to use a potential difference generated in the conductive body 22a. The power usage means 22 may be also configured by a sensor which detects deformation of the magnetostrictive material 21 from the potential difference generated in the conductive body 22a or power generating means which generates power from the potential difference generated in the conductive body 22a, for example.

Subsequently, an action will be described.

The power usage device 20 can cause the electric current to flow in the conductive body 22a by the inverse spin-hall effect, when the magnetostrictive material 21 is deformed by distortion or a volume change, and the spin current is generated, by causing the spin current to flow into the conductive body 22a by the magnetic field of the magnetic-field applying means. As a result, since the potential difference is generated in the conductive body 22a, the potential difference can be used by the power usage means 22.

In the power usage device 20, the potential difference can be generated in the conductive body 22a when the magnetostrictive material 21 with the double-supported beam structure is deformed in the perpendicular direction to the length direction thereof by configuring the magnetostrictive material 21 and the conductive body 22a similarly to the magnetostrictive material 11 and the conductive body 12a shown in Fig. 2, for example. Moreover, by configuring the magnetostrictive material 21 and the conductive body 22a similarly to the magnetostrictive material 11 and the conductive body 12a shown in Fig. 3, the potential difference can be generated in the conductive body 22a in accordance with the curving or twisting deformation of the cantilever-state magnetostrictive material 21.

Moreover, as shown in Fig. 6, in the power usage device 20, the magnetostrictive material 21 may be formed of a thin film, and a plurality of the conductive bodies 22a may be provided in parallel with each other at predetermined intervals on the surface of the magnetostrictive material 21. At this time, by combining it with the actuator 10 shown in Figs. 4, the elastic wave generated in the actuator 10 and propagated in the magnetostrictive material 21 can be detected by using the inverse spin-hall effect. Moreover, it may be also used as an elastic filter that can detect a signal with a predetermined frequency. Furthermore, since a detectable frequency can be changed by changing Young's modulus of the magnetostrictive material 11 by changing the magnetic field to be applied, it can be made into a variable filter.

### Example 1

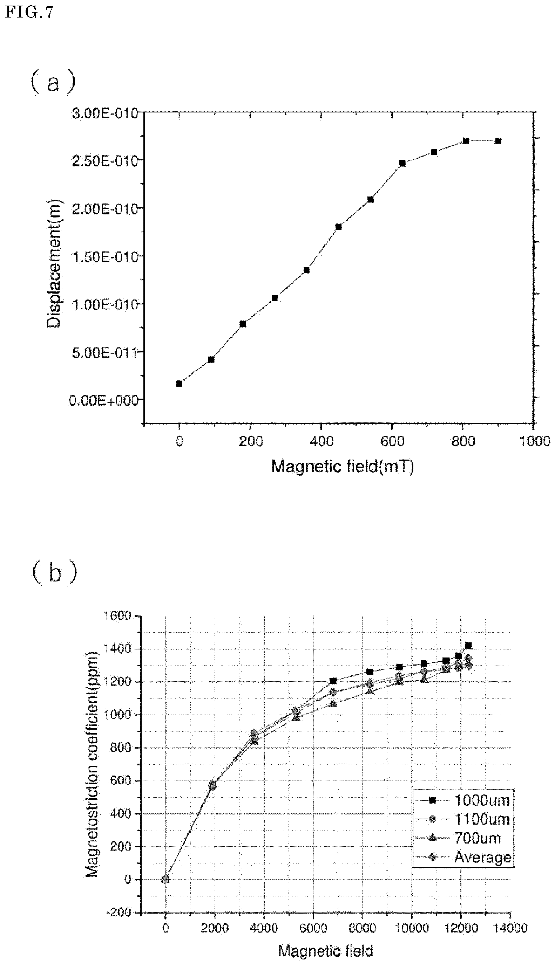

By using the actuator 10 shown in Fig. 1(a), displacement of the magnetostrictive material 11 was measured when the electric current was caused to flow in the conductive body 12a, and the magnetic field in the perpendicular direction to the aligning direction of the conductive body 12a and the magnetostrictive material 11 with the double-supported beam structure and the length direction of the conductive body 12a was applied. In the magnetostrictive material 11, a film of a giant-magnetostrictive material Terfenol-D (Tb_{0.36}Dy_{0.64}Fe_{1.9}) having the magnetostriction coefficient of 1250 ppm was formed on a silicon substrate, and a thickness of the giant-magnetostrictive material was set to 200 nm. The conductive body 12a was a Pt thin film with a thickness of 100 nm. The electric current caused to flow in the conductive body 12a was an AC current of 50 mA, 10kHz. In the measurement, an intensity of the applied magnetic field (Magnetic field) was changed from 0 mT to 900 mT by every 100 mT, and the displacement of the magnetostrictive material 11 was measured. A measurement result is shown in Fig. 7(a). For reference, a magnetic field of an NeFeB magnet is approximately 500 mT, and a magnetic field of MRI is approximately 1000 mT.

For comparison, as a case of only deformation by magnetostriction, a magnetic field in parallel with a length direction of a cantilever was applied to the cantilever with a surface layer made of Terfenol-D (Tb_{0.36}Dy_{0.64}Fe_{1.9}), which is a giant-magnetostrictive material, and a relationship between the applied magnetic field (Magnetic field) and a magnetostriction coefficient (Magnetostriction coefficient) was measured. Three types of cantilevers with lengths of 700 µm, 1000 µm, and 1100 µm were used, and an average value thereof was also acquired. The measurement result thereof is shown in Fig. 7(b).

As shown in Fig. 7(b), in the case of only deformation by magnetostriction, by applying the magnetic field in parallel to the length direction of the cantilever (length direction of the magnetostrictive material 11), the displacement by the magnetostriction is made larger, and it was confirmed that the magnetostriction coefficient of approximately 1250 ppm was obtained. Moreover, it was also confirmed that a curve until a maximum magnetostriction coefficient is reached forms an upward projecting shape. On the other hand, in the actuator 10, though the magnetic field is applied perpendicularly to the length direction of the magnetostrictive material 11 (length direction of the conductive body 12a), it was confirmed that the magnetostrictive material 11 was largely displaced. Furthermore, it was also confirmed that the curve until maximum displacement is reached is substantially linear. By comparing Fig. 7(a) and Fig. 7(b), the application directions of the magnetic field are different, and the curve shapes are also different and thus, the displacement by the spin current shown in Fig. 7(a) is different from that by the magnetostriction. The maximum distortion of the magnetostrictive material 11 shown in Fig. 7(a) is 1400 ppm, which indicates a value larger than the magnetostriction by genuine magnetic-field application.

### Example 2

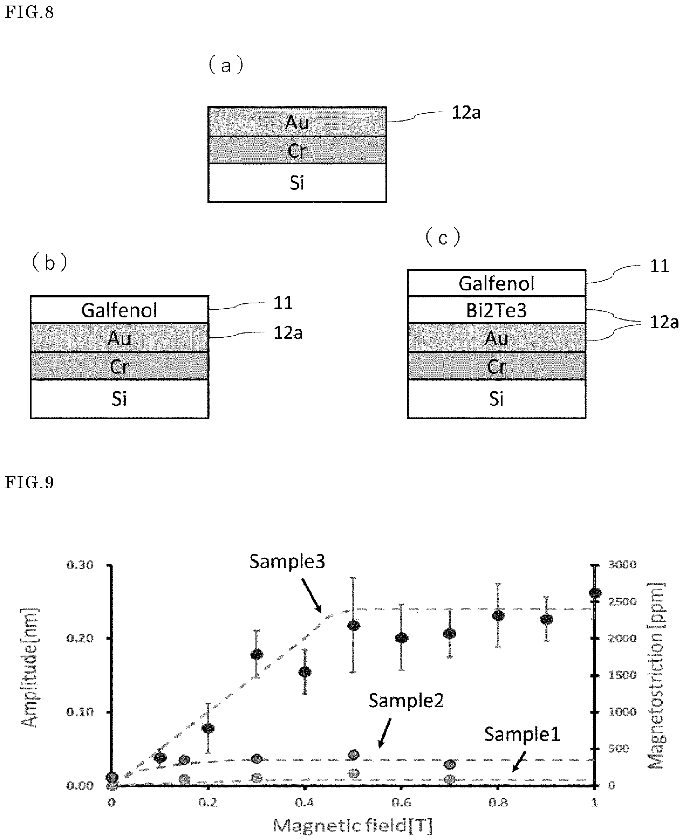

By using the actuator 10 shown in Fig. 1(a) and changing the material of the conductive body 12a, the displacement of the magnetostrictive material 11 was measured. Three types of samples, that is, the one for reference in which films of a Cr layer with a thickness of 20 nm and an Au layer with a thickness of 20 nm are formed on a Si substrate (with a thickness of 250 µm) and not having the magnetostrictive material 11 as shown in Fig. 8(a) (Sample 1), the one in which a film of the Galfenol (Ga_{0.2}Fe_{0.8}) layer of the giant-magnetostrictive material 11 with a thickness of 100 nm is further formed on the Au layer as shown in Fig. 8(b) (Sample 2), and the one in which a film of the Bi₂Te₃ layer with a thickness of 200 nm was formed between the Au layer and the Galfenol layer as shown in Fig. 8(c) (Sample 3) were prepared. The films of the Cr layer and the Au layer are formed by RF magnetron sputtering, the film of the Galfenole layer was formed by ion-beam sputtering, and the film of the Bi₂Te₃ layer was formed by pulse plating. Moreover, the Au layer and the Bi₂Te₃ layer form the conductive body 12a. Furthermore, each sample has a strip shape and its size is 7 mm long and 1 mm wide.

In the measurement, the electric current was caused to flow in the conductive body 12a, and the magnetic field in the perpendicular direction to the aligning direction of the conductive body 12a and the magnetostrictive material 11 with the double-supported beam structure and the length direction of the conductive body 12a was applied. Moreover, the voltage of 1.5 V, 1.5 kHz was applied to the conductive body 12a, and the AC current was caused to flow. The intensity of the applied magnetic field (Magnetic field) was changed from 0T to 1T, and the displacement (distortion; Magnetostriction) of the magnetostrictive material 11 was measured. The measurement result is shown in Fig. 9.

As shown in Fig. 9, in the Sample 1 without the magnetostrictive material 11, there was substantially zero distortion. Moreover, in the Sample 2 in which the conductive body 12a is formed of the Au layer, a maximum amplitude of the beam was 0.04 nm, and maximum distortion was 250 ppm. Moreover, in the Sample 3 in which the conductive body 12a is formed of the Au layer and the Bi₂Te₃ layer, the maximum amplitude of the beam was 0.24 nm, and the maximum distortion was approximately 2400 ppm. As described above, it was confirmed that the magnetostrictive material 11 can be driven particularly largely by injecting the spin current from the Bi₂Te₃ layer to the Galfenol layer. This is considered to be because the material containing Bi has a large spin-hall coefficient, and the similar effect can be expected not only from the Bi-Te-based alloy but also from the Bi-Se-based alloy. Moreover, Bi₂Te₃ is a topological insulator on a surface of which the spin current flows, and the similar effect can be expected from the other topological insulators such as the Sb-Te-based alloy.

### Example 3

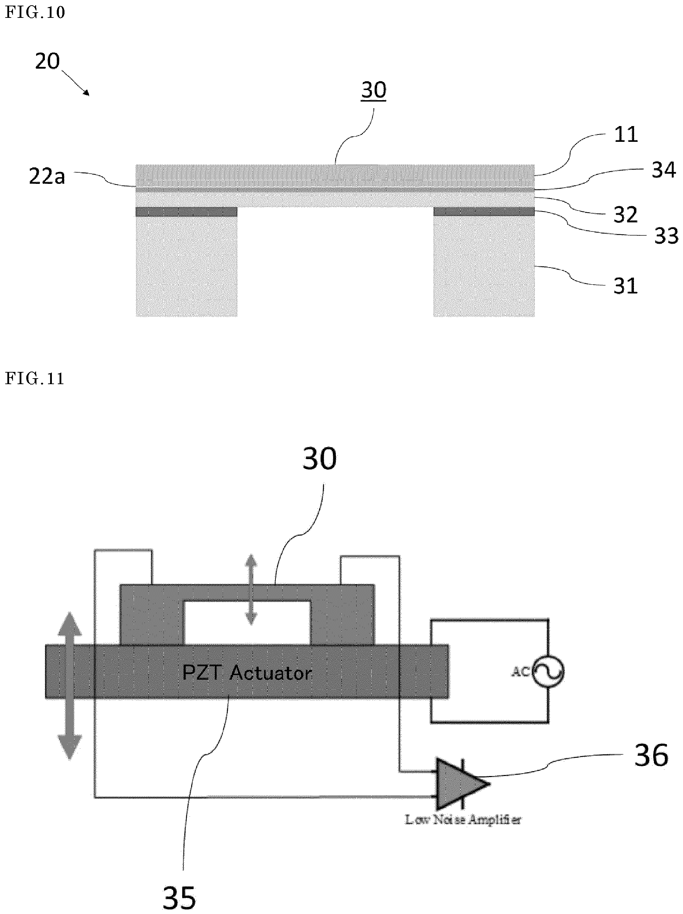

By using a diaphragm 30 shown in Fig. 10 as the power usage device 20, the potential difference generated in the conductive body 22a when the magnetostrictive material 21 is vibrated was measured. As shown in Fig. 10, the diaphragm 30 was manufactured as below by using a SOI (Silicon on Insulator) wafer having a BOX layer 33 (thickness of 1 µm) made of SiO₂ between a handle layer 31 (thickness of 300 µm) made of SiO₂ and a device layer 32 (thickness of 8 µm) made of Si. First, a seed layer 34 (thickness of 150 nm) made of Pt/Cr is formed on a surface of the device layer 32 in the SOI wafer, and a surface layer (thickness of 150 nm) made of the magnetostrictive material 21 of Terfenol-D (Tb₀ₓDy₁₋ₓFe_{y}) was further formed on the surface thereof by electrolytic plating. After that, by etching center parts of the handle layer 31 and the BOX layer 33, the diaphragm 30 made of the device layer 32, the seed layer 34, and the magnetostrictive material 21 with both end portions supported by the handle layer 31 and the BOX layer 33 was manufactured. Pt in the seed layer 34 corresponds to the conductive body 22a.

In the measurement, as shown in Fig. 11, in a state where the magnetic field orthogonal to the length direction and the thickness direction of the diaphragm 30 is applied to the magnetostrictive material 21, the diaphragm 30 was installed on a PZT actuator 35, and the PZT actuator 35 was vibrated. The intensity of the applied magnetic field was 500 mT, and a drive voltage of the PZT actuator 35 was 10V. By vibrating the PZT actuator 35, the spin current generated from the magnetostrictive material 21 of the resonated diaphragm 30 flows into Pt of the conductive body 22a by spin pumping, and the potential difference is generated on the both ends of the conductive body 22a by the inverse spin-hall effect and thus, the potential difference (voltage) was measured by a lock-in amplifier 36. The measured potential difference is an AC voltage.

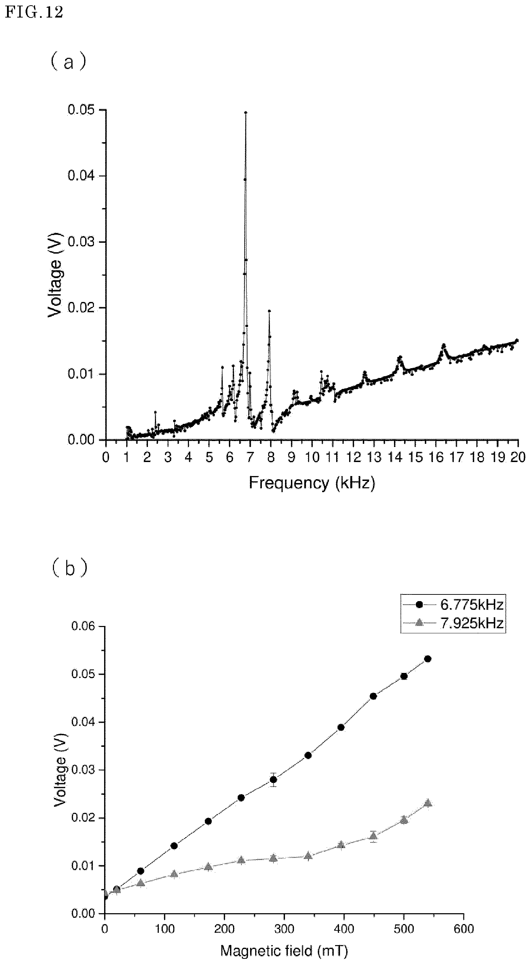

First, when a vibration frequency of the PZT actuator 35 was changed from 1 kHz to 20 kHz, a relationship between the frequency and the amplitude of the measured AC voltage was acquired, which is shown in Fig. 12(a). As shown in Fig. 12(a), the diaphragm 30 resonates strongly at 6.775 kHz and 7.925 kHz, and it was confirmed that the potential difference according to the vibration of the diaphragm 30 was generated.

Subsequently, when the applied magnetic field was changed from 0 mT to 550 mT, the amplitudes of the AC voltage with the resonant frequency at 6.775 kHz and 7.925 kHz were measured, which are shown in Fig. 12(b). As shown in Fig. 12(b), it was confirmed that, as the applied magnetic field gets larger, the potential difference generated at the resonant frequency also becomes larger.

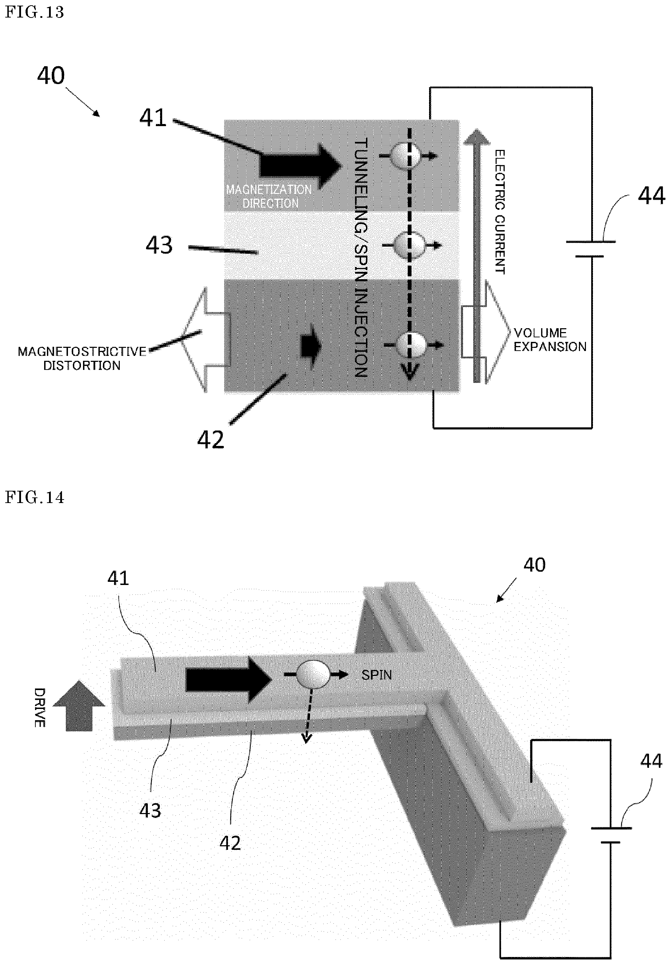

Fig. 13 and Fig. 14 illustrate an actuator of a second embodiment of the present invention.

As shown in Fig. 13, the actuator 40 of the second embodiment of the present invention forms a spin-valve structure and has a fixed layer 41, a free layer 42, a non-magnetic layer 43, and flow-in means. In the following description, description on effects and the like duplicated with the actuator 10 in the first embodiment of the present invention will be omitted.

The fixed layer 41 is formed of a ferromagnetic body and has a magnetization direction fixed in an in-plane direction. The fixed layer 41 is formed of Co, SmCo, Ni and the like, for example. The free layer 42 is formed of a magnetostrictive material, and a magnetization direction is the in-plane direction and is configured changeably between the same direction as the magnetization direction of the fixed layer 41 and a direction opposite thereto. The non-magnetic layer 43 is disposed between the fixed layer 41 and the free layer 42. The non-magnetic layer 43 is thin and is formed of metal without magnetism such as Cu or an insulator such as Al₂O₃, for example.

The flow-in means has voltage applying means 44 provided capable of applying a voltage between the fixed layer 41 and the free layer 42. The flow-in means is configured capable of causing the spin current to flow into the magnetostrictive material by applying a voltage by the voltage applying means 44 so as to inject the spin-polarized electric current from the fixed layer 41 to the free layer 42.

Subsequently, an action will be described.

The actuator 40 has a spin-valve structure and can cause the spin current to flow into the magnetostrictive material of the free layer 42 by applying the voltage between the fixed layer 41 and the free layer 42 by the voltage applying means 44. As a result, the distortion can be generated in the magnetostrictive material, the volume of the magnetostrictive material can be expanded, and the magnetostrictive material can be driven.

For example, as shown in Fig. 14, in the actuator 40, the fixed layer 41, the free layer 42, and the non-magnetic layer 43 may integrally form the beam shape. At this time, by applying the voltage by the voltage applying means 44, the spin-polarized electric current can be injected into the free layer 42. As a result, the magnetostrictive material is deformed, and the beam can be curved or twisted.

### Reference Signs List

10: Actuator
11: Magnetostrictive material
12: Flow-in means
12a: Conductive body
20: Power usage device
21: Magnetostrictive material
22: Power usage means
22a: Conductive body
30: Diaphragm
31: Handle layer
32: Device layer
33: BOX layer
34: Seed layer
35: PZT actuator
36: Lock-in amplifier
40: Actuator
41: Fixed layer
42: Free layer
43: Non-magnetic layer
44: Voltage applying means

## Claims

1. An actuator, comprising:
a magnetostrictive material; and
flow-in means provided capable of causing a spin current to flow into the magnetostrictive material.

2. The actuator according to claim 1, wherein
the flow-in means has a conductive body provided along a surface of the magnetostrictive material and electric-current supply means which causes an electric current to flow in the conductive body, and the conductive body is capable of generating the spin current when the electric current flows.

3. The actuator according to claim 2, further comprising:
magnetic-field applying means which applies, to the magnetostrictive material, a magnetic field orthogonal or diagonal to a direction of the electric current caused to flow in the conductive body by the electric-current supply means and a flow direction of the spin current generated in the conductive body.

4. The actuator according to claim 2 or 3, wherein
the conductive body is formed of Pt, W, Ta, a Bi-Te-based alloy, a Bi-Se-based alloy or a Sb-Te-based alloy.

5. The actuator according to any one of claims 1 to 4, wherein
the magnetostrictive material forms a beam shape and is provided capable of curving and/or twisting deformation by the flow-in spin current.

6. A power usage device, comprising:
a magnetostrictive material capable of generating a spin current when deformed; and
power usage means provided so that the spin current flows in and using a potential difference generated by the flow-in spin current.

7. The power usage device according to claim 6, wherein
the power usage means has a conductive body provided along a surface of the magnetostrictive material so that the spin current flows in and an electric current flows and is configured to use a potential difference generated in the conductive body.

8. The actuator according to claim 7, further comprising:
magnetic-field applying means which applies, to the magnetostrictive material, a magnetic field orthogonal or diagonal to a direction of the electric current flowing in the conductive body and a flow direction of the spin current flowing into the conductive body.

9. The power usage device according to claim 7 or 8, wherein
the conductive body is formed of Pt, W, Ta, a Bi-Te-based alloy, a Bi-Se-based alloy or a Sb-Te-based alloy.

10. The power usage device according to any one of claims 6 to 9, wherein
the magnetostrictive material forms a beam shape and is provided capable of generating the spin current by curving and/or twisting deformation.

11. The power usage device according to any one of claims 6 to 10, wherein
the power usage means is formed of a sensor which detects deformation of the magnetostrictive material from the potential difference or power generating means which generates power from the potential difference.

12. The actuator according to claim 1, further comprising:
a fixed layer made of a ferromagnetic body and having a magnetization direction fixed;
a free layer made of the magnetostrictive material and having a changeable magnetization direction; and
a non-magnetic layer disposed between the fixed layer and the free layer, wherein
the flow-in means has voltage applying means provided capable of applying a voltage between the fixed layer and the free layer and is configured to inject a spin-polarized electric current from the fixed layer to the free layer so that the spin current can flow into the magnetostrictive material by applying the voltage by the voltage applying means.

13. The actuator according to claim 12, wherein
the fixed layer, the free layer, and the non-magnetic layer integrally form a beam shape and are provided capable of curving and/or twisting deformation by the spin-polarized electric current injected into the free layer.
